# EUROPEAN PATENT APPLICATION

(11) **EP 3 093 950 A1**
(43) Date of publication of application: **16.11.2016**
(21) Application number: 14877705.5
(22) Date of filing: 08.01.2014
(51) Int. Cl.: H02J 13/00, G01R 21/00

(54) **SIGNAL PROCESSING SYSTEM, SIGNAL PROCESSING METHOD, AND SIGNAL PROCESSING PROGRAM**

(71) Applicant: Informetis Corporation, Tokyo 108-0074 (JP)
(72) Inventor: TADANO, Taro, Tokyo 108-0074 (JP)
(74) Representative: Epping - Hermann - Fischer
(86) International application number: PCT/JP2014/050126
(87) International publication number: WO 2015/104804

(57) **Abstract**

There are provided a signal processing system, a signal processing method, and a signal processing program that visualize power consumption statuses, use statuses, or the like of a plurality of electrical devices in a form of causing a user to take interest.

The signal processing system 1 includes a data detection part 100 that detects analog waveform data of a current and a voltage supplied to a plurality of electrical devices, a data conversion part 110 that converts the analog waveform data detected by the data detection part 100 into digital waveform data, a separation part 205 that separates the digital waveform data into individual pieces of digital waveform data which respectively correspond to the plurality of electrical devices, an operation estimation part 210 that estimates an operation status of each of the plurality of electrical devices by analyzing the individual digital waveform data, and an output part 220 that outputs the operation status of each of the plurality of electrical devices based on an estimation result from the operation estimation part 210, so as to allow visual recognition.

## Description

### Technical Field

The present invention relates to a signal processing system, a signal processing method, and a signal processing program. Particularly, the present invention relates to the signal processing system, the signal processing method, and the signal processing program in which operation statuses of a plurality of electrical devices are visualized.

### Background Art

In the related art, a power monitoring device has been known (for example, see PTL 1). The power monitoring device is a power monitoring device that recognizes a state of an electrical device based on user feedback. The power monitoring device includes a measuring module which measures power consumption features of a power source and supplies power to a plurality of electrical devices, a change detection-and-search module which is combined with the measuring module and detects and calculates a change of the power consumption feature, and an electrical device signature database. If a change is detected, the change detection-and-search module performs a search in the electrical device signature database by the detected change, obtains one or more electrical device candidates which correspond to the change, and obtains a state of the electrical device candidate or a combination of states of a plurality of electrical device candidates. According to the power monitoring device disclosed in PTL 1, it is possible to investigate causes of power consumption of each of the electrical devices and to reduce the quantity of consumed power.

### Citation List

### Patent Literature

[PTL 1] JP-A-2012-16270

### Summary of Invention

### Technical Problem

However, in the power monitoring device as disclosed in PTL 1, it is impossible to output a power consumption status of each of the electrical devices and a use status of each of the electrical devices so as to allow visual recognition of a user.

Accordingly, an object of the present invention is to provide a signal processing system, a signal processing method, and a signal processing program that visualize power consumption statuses, use statuses, or the like of a plurality of electrical devices in a form causing a user to take interest.

### Solution to Problem

To achieve the above object, according to the present invention, there is provided a signal processing system that includes a data detection part that detects analog waveform data of a current and a voltage supplied to a plurality of electrical devices, a data conversion part that converts the analog waveform data detected by the data detection part into digital waveform data, a separation part that separates the digital waveform data into individual pieces of digital waveform data which respectively correspond to the plurality of electrical devices, an operation estimation part that estimates an operation status of each of the plurality of electrical devices by analyzing the individual digital waveform data, and an output part that outputs the operation status of each of the plurality of electrical devices based on an estimation result from the operation estimation part, so as to allow visual recognition.

In the signal processing system, the output part may output an operation status image indicating the operation status onto an area image indicating an area in which the plurality of electrical devices is installed.

In the signal processing system, the operation estimation part may estimate the operation status over time. The signal processing system may further include an output image generation part that changes the operation status image which is superimposed and output on the area image, based on sequential estimation of the operation estimation part.

The signal processing system may further include an estimation result storage part and an image storage part. The estimation result storage part stores estimation result information indicating an estimation result of the operation estimation part. The image storage part stores the operation status image corresponding to the estimation result information. In the signal processing system, the output image generation part may output the operation status image corresponding to the estimation result information to the output part.

In the signal processing system, the operation status image may include a character image.

In the signal processing system, the output image generation part may cause the operation status image corresponding to each of the plurality of electrical devices to be disposed at a position of the area image corresponding to a position designation instruction, in accordance with the position designation instruction of designating a position, which is received from the outside.

In the signal processing system, the output image generation part may cause the operation status image corresponding to each of a plurality of electrical devices which do not correspond to the position designation instruction, to be moved on the area image.

The signal processing system may further include an estimation data storage part that stores unique operation status information indicating an operation status unique to each of the plurality of electrical devices, in correlation with each of the plurality of electrical devices. In the signal processing system, the operation estimation part may compare the individual digital waveform data and the unique operation status information to each other so as to estimate the operation status of each of the plurality of electrical devices.

To achieve the above object, according to the present invention, there is provided a signal processing method that includes a data detecting step of detecting analog waveform data of a current and a voltage supplied to a plurality of electrical devices, a data converting step of converting the analog waveform data which is detected in the data detecting step, into digital waveform data, a separating step of separating the digital waveform data into individual digital waveform data corresponding to each of the plurality of electrical devices, an operation estimating step of estimating an operation status of each of the plurality of electrical devices by analyzing the individual digital waveform data, and an outputting step of outputting the operation status of each of the plurality of electrical devices based on an estimation result in the operation estimating step, so as to allow visual recognition.

To achieve the above object, according to the present invention, there is provided a signal processing program which causes a computer to execute a data detecting function of detecting analog waveform data of a current and a voltage supplied to a plurality of electrical devices, a data converting function of converting the analog waveform data which is detected through the data detecting function, into digital waveform data, a separating function of separating the digital waveform data into individual digital waveform data corresponding to each of the plurality of electrical devices, an operation estimating function of estimating an operation status of each of the plurality of electrical devices by analyzing the individual digital waveform data, and an outputting function of outputting the operation status of each of the plurality of electrical devices based on an estimation result in the operation estimating function, so as to allow visual recognition.

### Advantageous Effects of Invention

According to the signal processing system, the signal processing method, and the signal processing program relating to the present invention, it is possible to provide a signal processing system, a signal processing method, and a signal processing program that visualize power consumption statuses, use statuses, or the like of a plurality of electrical devices in a form causing a user to take interest.

### Brief Description of Drawings

Fig. 1 is a diagram of an outline of a signal processing system according to an embodiment.
Fig. 2 is a functional configuration block diagram of the signal processing system according to the embodiment.
Fig. 3 is a diagram illustrating an example of a display method of an operation status image in the signal processing system according to the embodiment.
Fig. 4 is a diagram illustrating another example of the display method of the operation status image in the signal processing system according to the embodiment.
Fig. 5 is a diagram illustrating yet another example of the display method of the operation status image in the signal processing system according to the embodiment.
Fig. 6 is a diagram of a method for displaying additional information on an operation status image in the signal processing system according to the embodiment.
Fig. 7 is a processing flowchart of the signal processing system according to the embodiment.
Fig. 8 is a hardware configuration diagram of the signal processing system according to the embodiment.

### Description of Embodiments

### [Embodiment]

### (Outline of Signal Processing System 1)

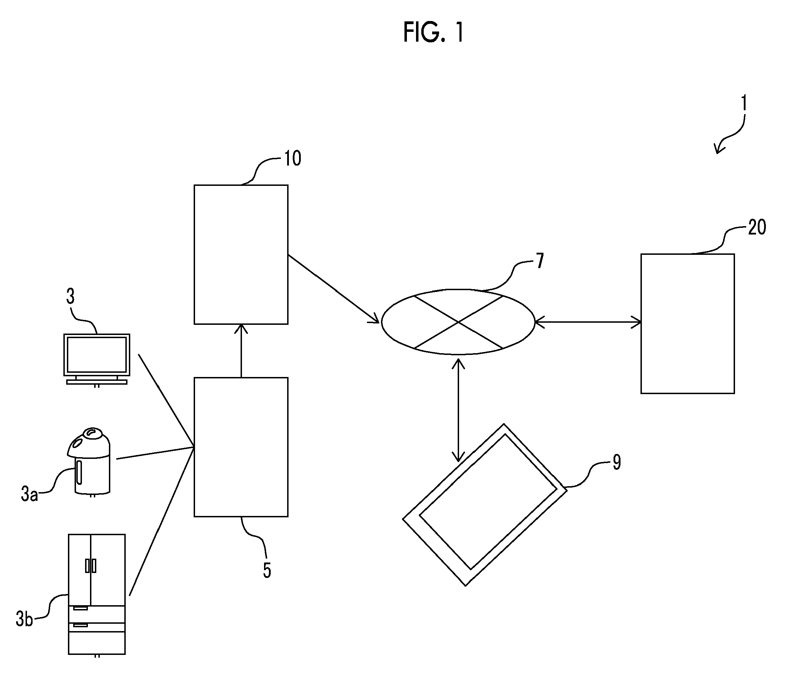

Fig. 1 illustrates an outline of a signal processing system according to an embodiment.

The signal processing system 1 according to the embodiment obtains information regarding currents and voltages of a plurality of electrical devices and analyzes the obtained information. Thus, the signal processing system 1 estimates an operation status of each of the plurality of electrical devices. The signal processing system 1 outputs operation statuses of the plurality of electrical devices based on information indicating an estimation result, so as to allow visual recognition. For example, the signal processing system 1 generates an image obtained by superimposing an image indicating an operation status of each of electrical devices on an image of a room floor plan in which a plurality of electrical devices is installed. Thus, according to the signal processing system 1, it is possible to output the operation statuses of the plurality of electrical devices so as to allow visual recognition.

Specifically, the signal processing system 1 includes a measuring unit 10 and a processing unit 20. The measuring unit 10 measures information regarding currents and voltages of a plurality of electrical devices (for example, a television 3, an electric pot 3a, a refrigerator 3b, and the like) to which power is supplied from a power distribution board 5. The processing unit 20 obtains information indicating a result obtained by measuring of the measuring unit 10, through a communication network 7 and separates the obtained information into pieces of information which respectively correspond to a plurality of electrical devices, and then analyzes the separated pieces of information. The signal processing system 1 supplies image information to a communication terminal 9. This image information indicates an image obtained by superimposing an image indicating an operation status of each of the electrical devices on a floor plan as an area image based on information indicating a result which is obtained by analysis of the processing unit 20 and/or an analysis result. Thus, it is possible to cause a user having the communication terminal 9 to visually understand the operation statuses of the plurality of electrical devices.

The plurality of electrical devices is not limited to the above examples, and includes various home appliances to which power is supplied. The communication network 7 includes the Internet, a mobile communication network, and/or a wired or wireless LAN, and the like. The communication terminal 9 includes a mobile phone, a smart phone, a tablet terminal, a personal computer, and the like. The processing unit 20 may directly obtain information indicating the result which is obtained by measuring of the measuring unit 10 in near field communication or the like.

### (Details of Signal Processing System 1)

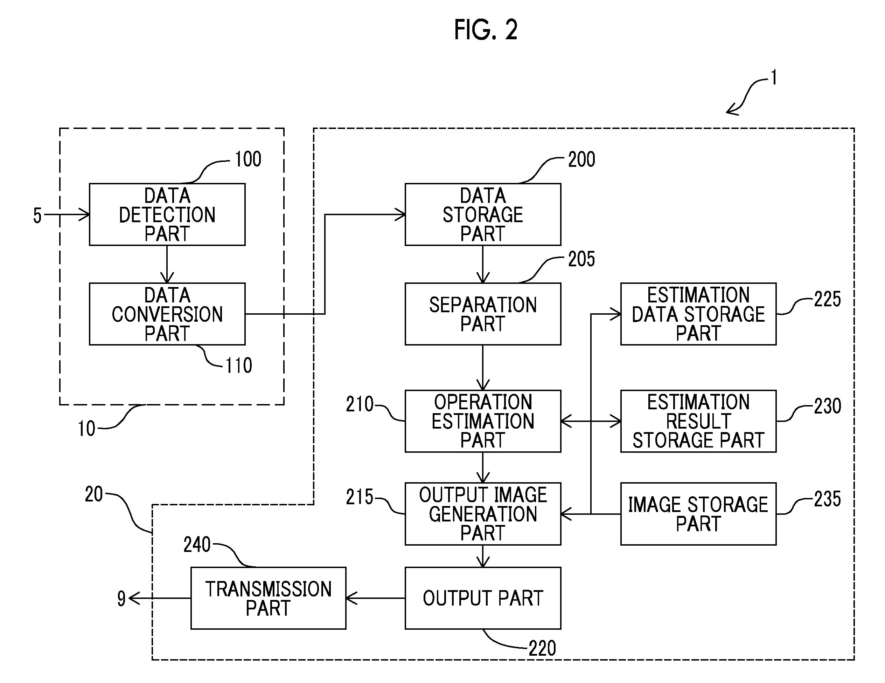

Fig. 2 illustrates an example of functional configuration blocks of the signal processing system according to the embodiment.

The signal processing system 1 includes the measuring unit 10 and the processing unit 20. The measuring unit 10 includes a data detection part 100 and a data conversion part 110. The data detection part 100 detects information regarding a current and a voltage which are supplied to each of the plurality of electrical devices from the power distribution board 5. The data conversion part 110 converts the information detected by the data detection part 100 into predetermined information.

The processing unit 20 includes a data storage part 200, a separation part 205, an operation estimation part 210, an output image generation part 215, and an output part 220. The data storage part 200 stores information converted by the data conversion part 110. The separation part 205 separates pieces of information which respectively correspond to the plurality of electrical devices, from the information. The operation estimation part 210 estimates an operation status of each of the plurality of electrical devices. The output image generation part 215 controls an output format of an estimation result of the operation estimation part 210. The output part 220 outputs information indicating the operation status of each of the plurality of electrical devices. The processing unit 20 includes an estimation data storage part 225, an estimation result storage part 230, an image storage part 235, and a transmission part 240. The estimation data storage part 225 stores information indicating the operation status unique to each of the plurality of electrical devices, in advance. The estimation result storage part 230 stores an operation result of the operation estimation part 210. The image storage part 235 stores image information of an area image, a character image, or the like. The transmission part 240 transmits information output by the output part 220 to the communication terminal 9.

### (Data Detection Part 100)

The data detection part 100 detects analog waveform data of currents and voltages which are supplied to the plurality of electrical devices. For example, the data detection part 100 is installed at a portion of an ampere meter on a main side of the power distribution board 5 which is provided in a building such as a house. The data detection part 100 detects waveform data of a voltage within a predetermined voltage range, and waveform data of a predetermined current or a current within a predetermined current range. The data detection part 100 supplies the detected analog waveform data to the data conversion part 110.

### (Data Conversion Part 110)

The data conversion part 110 converts the analog waveform data detected by the data detection part 100 into digital waveform data. The data conversion part 110 supplies the digital waveform data obtained through conversion to the processing unit 20. The measuring unit 10 and the processing unit 20 are connected to each other so as to enable transmission and reception of information through the communication network 5. In this case, the measuring unit 10 may further include a measuring unit-side transmission part (not illustrated) that transmits the digital waveform data converted by the data conversion part 110 to the processing unit 20. The processing unit 20 may further include a processing unit-side reception part (not illustrated) that receives the digital waveform data.

### (Data Storage Part 200)

The data storage part 200 stores the digital waveform data supplied from the data conversion part 110. The data storage part 200 stores the digital waveform data in correlation with a point of time when the analog waveform data which is a base of the digital waveform data is detected. The data storage part 200 stores the digital waveform data for a predetermined period or until a deletion command for the digital waveform data is received from the outside. The data storage part 200 supplies the stored digital waveform data to the separation part 205.

### (Separation Part 205)

The separation part 205 separates the digital waveform data stored in the data storage part 200 into pieces of individual digital waveform data which respectively correspond to the plurality of electrical devices. As an example, the separation part 205 separates the digital waveform data into the pieces of individual digital waveform data as pieces of data which respectively correspond to the plurality of electrical devices, by using a factorial HMM (hidden Markov model). Specifically, the separation part 205 calculates a model parameter obtained by modeling the operation status of each of the plurality of electrical devices in advance. The separation part 205 separates the digital waveform data obtained from the data storage part 200 into state variables as plural pieces of individual digital waveform data by using the Factorial HMM for each time sequence. The separation part 205 detects a state variable suitable for a model parameter of the same electrical device among the state variables obtained through separation. When one electrical device is expressed by a plurality of state variables, the separation part 205 may detect the plurality of state variables as state variables corresponding to the one electrical device. The separation part 205 supplies the plural pieces of individual digital waveform data which are obtained through separation, to the operation estimation part 210.

### (Operation Estimation Part 210, Estimation Data Storage Part 225, and Estimation Result Storage Part 230)

The operation estimation part 210 analyzes the individual digital waveform data and thus estimates the operation status of each of the plurality of electrical devices. That is, the operation estimation part 210 estimates the operation status of each of the plurality of electrical devices, based on the plurality of state variables as the individual digital waveform data. The operation estimation part 210 may estimate the operation status with time.

Specifically, the signal processing system 1 includes an estimation data storage part 225 that stores unique operation status information indicating an operation status unique to each of the plurality of electrical devices, in advance in correlation with each of the plurality of electrical devices. The operation estimation part 210 compares the individual digital waveform data and the unique operation status information stored in the estimation data storage part 225, to each other and thus estimates the operation status of each of the plurality of electrical devices. The information indicating the operation status includes information indicating the consumed power of each of the plurality of electrical devices, information indicating an operation level, an operation period, and operation time, information indicating an abnormal state, information indicating a deterioration state, information indicating the number of times of using the electrical devices and a use frequency, and/or position information indicating a position at which the electrical device is present in a predetermined area.

The operation estimation part 210 may analyze demand breakdown of power of a user from information of each of the plurality of electrical devices. The operation estimation part 210 may deduce a recommended use method of electrical devices in accordance with a demand response or a fluctuating price by analyzing demand breakdown. The operation estimation part 210 may deduct predetermined information for performing suggestion to a user, based on information of each of the plurality of electrical devices. Examples of the predetermined information include information regarding recommendation of performing maintenance of an electrical device, recommendation of replacement, a report of forgetting shut-off, and/or a report of fire or destruction.

The predetermined information may be information deducted by combining information of each of the plurality of electrical devices. Examples of the predetermined information include information obtained by estimating an act of a user based on operation statuses of the plurality of electrical devices and/or information obtained by estimating a situation of a user based on abnormality of each of the plurality of electrical devices.

The operation estimation part 210 supplies information indicating the estimation result to the estimation result storage part 230 and the output image generation part 215. The estimation result storage part 230 stores estimation result information indicating the estimation result from the operation estimation part 210. The estimation result storage part 230 may store the estimation result information correlated with a point of time when the analog waveform data which is a base of the digital waveform data including the individual digital waveform data is detected by the data detection part 100, and this digital waveform data is used in estimation of the operation estimation part 210.

### (Output Image Generation Part 215, Output Part 220, and Image Storage Part 235)

The output part 220 is controlled by the output image generation part 215 so as to output the operation status of each of the plurality of electrical devices based on the estimation result from the operation estimation part 210, so as to allow visual recognition. The output part 220 supplies output information to the transmission part 240.

Specifically, the output part 220 is controlled by the output image generation part 215 so as to generate an image obtained by superimposing an operation status image indicating the operation status in the vicinity of a position at which each of the plurality of electrical devices is installed, in an area image indicating a predetermined area in which the plurality of electrical devices is installed. Here, the signal processing system 1 further include an image storage part 235 that stores the operation status image corresponding to at least the estimation result information and the area image of the area in which the plurality of electrical devices is installed.

The output image generation part 215 obtains the operation status image corresponding to the estimation result information which indicates the estimation result from the operation estimation part 210, from the image storage part 235, obtains the area image from the image storage part 235, and supplies an image generated by superimposing the operation status image on the obtained area image, to the output part 220. The output part 220 outputs an image received from the output image generation part 215. For example, the output part 220 outputs the image to the transmission part 240 and transmits the image to the communication terminal 9 from the transmission part 240. The communication terminal 9 displays the transmitted image on a display part and the like of the communication terminal 9.

The output image generation part 215 may change the operation status image which is superimposed on the area image and output to the output part 220, based on sequential estimation of the operation estimation part 210. For example, the output image generation part 215 may change a color, a shape, or a form of the operation status image, or a combination thereof. The output image generation part 215 may supply the operation status image which respectively corresponds to each of the plurality of electrical devices, to the output part 220 in accordance with a position designation instruction for designating positions of electrical devices in the predetermined area and may supply an image disposed at a position of the area image in accordance with the position designation instruction to the output part 220.

Here, the image storage part 235 stores the following images as the operation status image: image indicating consumed power of an electrical device (for example, a circular image having a diameter varying depending on a numeric value of the consumed power and the quantity of consumed power, an image denoted by a color depending on the amount of the consumed power, and the like), an image indicating electric charges corresponding to the consumed power of the electrical device, and/or an image indicating a CO2 discharging quantity corresponding to the consumed power of the electrical device (for example, image of a tree), and the like. The image storage part 235 stores the following images: an image of a region including a plurality of multiple-dwelling houses, an image of a multiple-dwelling house, an area image such as a floor plan of a house, a plurality of area division images (for example, a plurality of room images when the area image is a floor plan of the house) constituting the area image, and/or an image of the electrical device, and the like.

The image storage part 235 may store a plurality of deterioration images in accordance with a change from an initial value of the consumed power of each of the plurality of electrical devices. The deterioration image indicates a state where each of the plurality of electrical devices is deteriorated. The image storage part 235 stores a character image as the operation status image. The character image is an image illustrating, for example, objects of living things including a person, plants, fungi, and the like, and/or eggs.

### (Display Method of Operation Status Image)

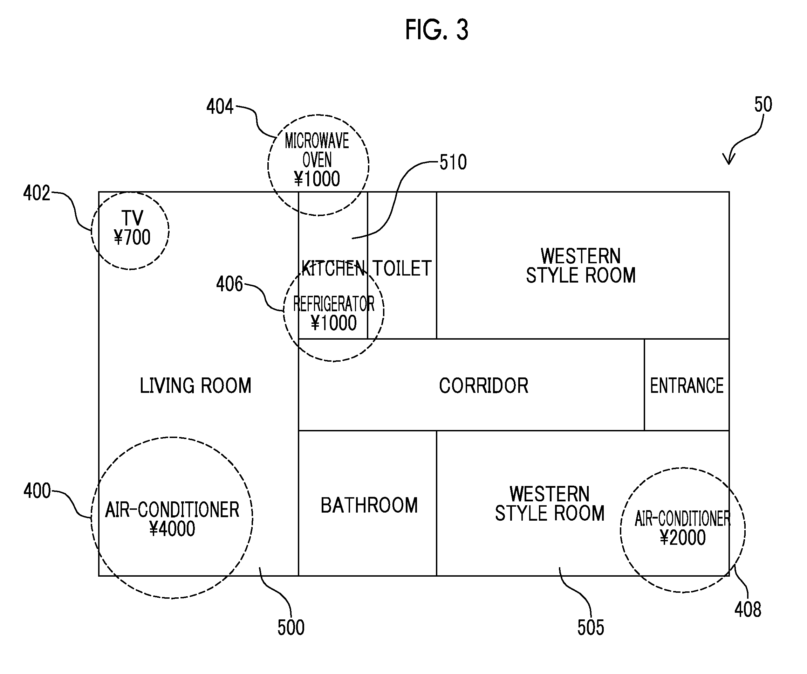

Fig. 3 illustrates an example of a display method of the operation status image in the signal processing system according to the embodiment. Specifically, Fig. 3 illustrates a diagram in which the signal processing system 1 outputs operation statuses of a plurality of electrical devices which are installed in a house having predetermined layout, so as to enable visual recognition.

The operation estimation part 210 of the signal processing system 1 estimates the operation statuses of the plurality of electrical devices installed in a house. The output image generation part 215 obtains an operation status image corresponding to the estimation result of the operation estimation part 210, from the image storage part 235. The output image generation part 215 obtains a layout image of the house from the image storage part 235 and outputs an image obtained by superimposing the operation status image on the layout image, from the output part 220.

For example, the output image generation part 215 generates an image obtained by assigning colors to the area division images of the area image 50 as an image of a floor plan which includes a plurality of area division images (for example, area division image 500, area division image 505, and area division image 510). That is, the output image generation part 215 generates an image displayed by superimposing the plurality of area division images which are colored in accordance with the quantity of consumed power and/or the electric charges of each room, on the area image 50.

As illustrated in Fig. 3, the output image generation part 215 generates an operation status image 400, an operation status image 402, an operation status image 404, an operation status image 406, and an operation status image 408. An example of the operation status image 400 includes an image configured from a circular image having a diameter in accordance with consumed power of an air-conditioner, and an image indicating the electric charges. An example of the operation status image 402 includes an image configured from a circular image having a diameter in accordance with consumed power of a television, and an image indicating the electric charges. An example of the operation status image 404 includes an image configured from a circular image having a diameter in accordance with consumed power of a microwave oven, and an image indicating the electric charges. An example of the operation status image 406 includes an image configured from a circular image having a diameter in accordance with consumed power of a refrigerator, and an image indicating the electric charges. An example of the operation status image 408 includes an image configured from a circular image having a diameter in accordance with consumed power of an air-conditioner, and an image indicating the electric charges.

That is, the output image generation part 215 generates an image which is displayed by superimposing an image configured from a circular image having a diameter in accordance with consumed power of the electrical device and an image indicating the electric charges, at a position of the area image 50 corresponding to a location in which an electrical device is installed. The consumed power of the electrical device may be represented by using a bar graph, a circular graph, or the like. The output image generation part 215 grasps positions of the plurality of electrical devices in a predetermined area, from information stored in the estimation data storage part 225.

The output image generation part 215 may generate an image displayed by superimposing the operation status image indicating the CO2 discharging quantity or the use frequency on the area image 50. For example, the output image generation part 215 uses a predetermined image of a tree as the operation status image indicating the CO2 discharging quantity. That is, the output image generation part 215 determines a reference quantity of CO2 absorbed for a year by a predetermined tree, and generates an image displayed by superimposing images of pieces of trees in accordance with a numeric number obtained by subtracting a CO2 quantity which is discharged by using the electrical device from the reference quantity, on the area image 50.

When the communication terminal 9 is, for example, a tablet terminal, the output image generation part 215 may change the area image 50 and the operation status image which is superimposed on the area image 50 and displayed. For example, the image storage part 235 stores an image indicating a plurality of rooms as the area image, an image of the entirety of a house configured from a plurality of rooms, an image of the entirety of a block configured from a plurality of houses, an image of the entirety of an apartment configured from a plurality of blocks. The output image generation part 215 changes the area image using an image stored in the image storage part 235, in accordance with expansion or reduction of a display area by a flicking operation on the tablet terminal. The output image generation part 215 generates an image displayed by superimposing the operation status image corresponding to each of the changed area image on the changed area image.

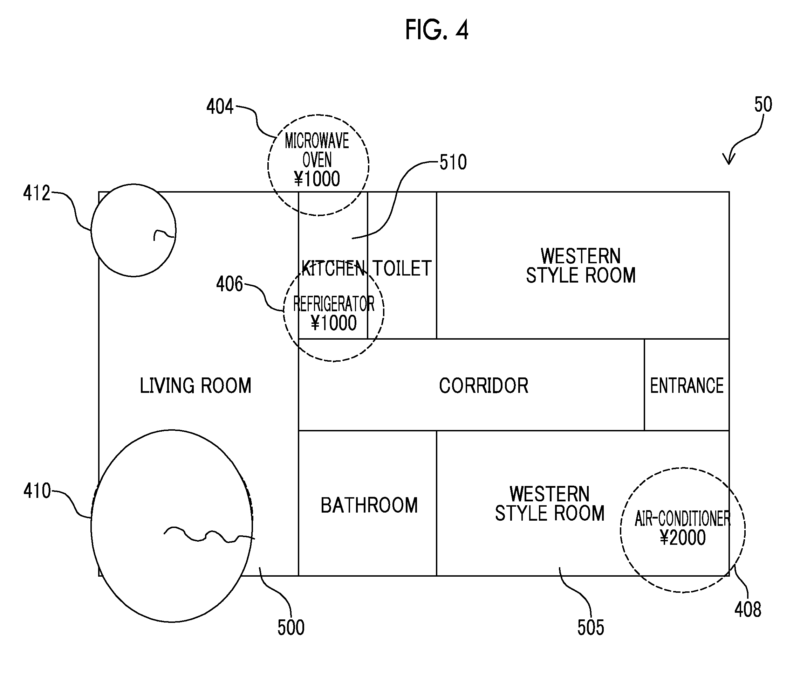

Fig. 4 illustrates another example of a display method of the operation status image in the signal processing system according to the embodiment. Specifically, Fig. 4 is a diagram illustrating a form in which the operation status of each of a plurality of electrical devices is visualized when the signal processing system 1 is started, in a case where the signal processing system 1 outputs operation statuses of the plurality of electrical devices which are installed in a house having predetermined layout, so as to enable visual recognition.

For example, when a new electrical device is added in the signal processing system 1 or when a new electrical device is found in the signal processing system 1, the operation estimation part 210 supplies an estimation result including information indicating presence of a new electrical device, to the output image generation part 215. When the estimation result is obtained, the output image generation part 215 generates an image displayed by superimposing an image causing a user to take interest in the vicinity of a position of the area image 50, at which the new electrical device is present. As an example, the image storage part 235 stores an image (operation status image 410 and operation status image 412) to which an egg is assigned, as an image causing a user to take interest. The output image generation part 215 outputs the image displayed by superimposing the operation status image 410 and the operation status image 412 on the area image 50 to the output part 220. The output image generation part 215 may gradually change the operation status image 410 and the operation status image 412 with time (for example, the output image generation part 215 generates an image displayed by superimposing images to which eggs are gradually assigned on the area image 50).

The output image generation part 215 may move an operation status image corresponding to each of a plurality of electrical devices which do not correspond to the position designation instruction, on the area image in accordance with an instruction from the outside. The output image generation part 215 may randomly move the operation status image corresponding to each of a plurality of electrical devices which do not correspond to the position designation instruction, on the area image 50 until the electrical devices correspond to the position designation instruction.

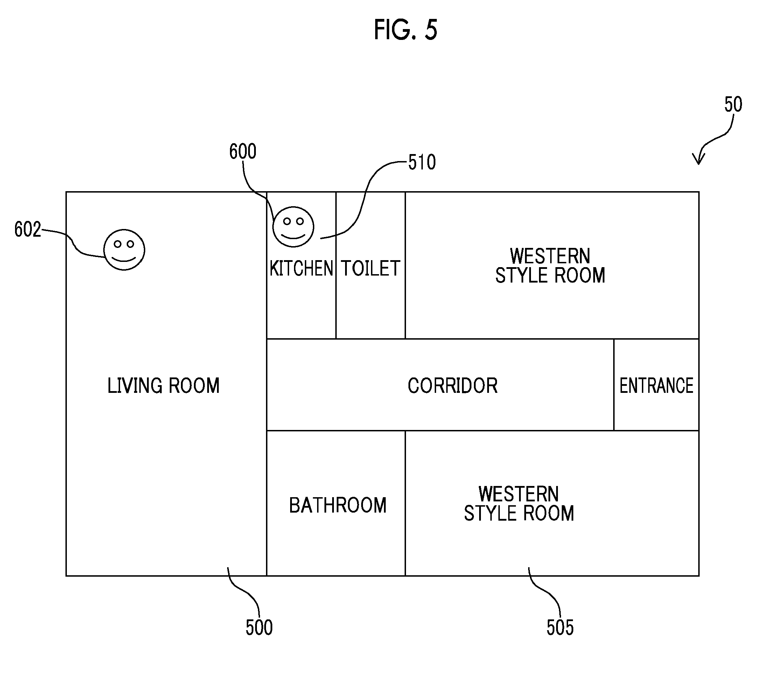

Fig. 5 illustrates yet another example of the display method of the operation status image in the signal processing system according to the embodiment. Specifically, Fig. 5 illustrates an example in which the character image is superimposed on the area image when the signal processing system 1 outputs the operation statuses of the plurality of electrical devices installed in a house which has predetermined layout, so as to enable visual recognition.

For example, the output image generation part 215 generates an image displayed by superimposing a character image (for example, character image 600 and character image 602) at the surroundings of an electrical device which is an electrical device consuming power and consumes power equal to or greater than a predetermined quantity of power consumption, in accordance with the estimation result of the operation estimation part 210. The operation estimation part 210 may estimate operation states of the plurality of electrical devices along a time sequence. In this case, the output image generation part 215 may generate a plurality of images displayed by superimposing a character image on the surroundings of each of the plurality of electrical devices in which consumed power is changed along the time sequence, and the image generation part 215 may generate a video obtained by linking a plurality of images to each other along the time sequence. Thus, the signal processing system 1 can substantially reproduce an act of a user who uses a plurality of electrical devices, on the communication terminal 9.

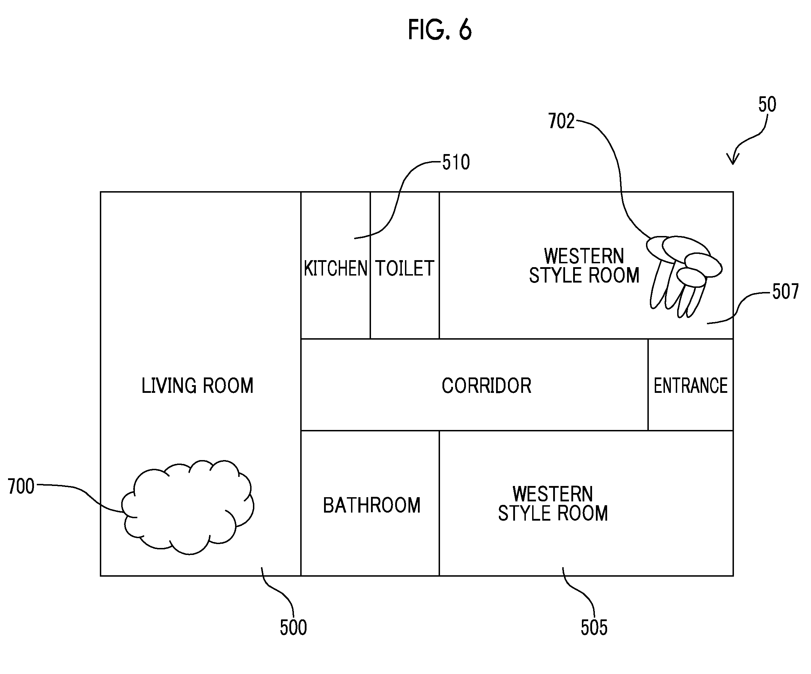

Fig. 6 illustrates an example of a method of displaying additional information on the operation status image in the signal processing system according to the embodiment.

Specifically, the output image generation part 215 generates an image displayed by superimposing an image corresponding to the use status of an electrical device, which is indicated by the estimation result from the operation estimation part 210, on the area image 50. For example, the output image generation part 215 generates an image displayed by superimposing an image 700 indicating dust, garbage, or the like on the area division image 500, when an operation status of an electric vacuum cleaner in the estimation result from the operation estimation part 210 indicates that the electric vacuum cleaner is not operated for a predetermined first period in an area corresponding to an area division image 500. When an operation status of an electric vacuum cleaner in the estimation result from the operation estimation part 210 indicates that the electric vacuum cleaner is not operated for a predetermined second period (satisfy a relationship of the first period < the second period) in an area corresponding to an area division image 507, the output image generation part 215 generates an image displayed by superimposing an image 702 indicating a mushroom on the area division image.

### (Outline of Processing Flow of Signal Processing System)

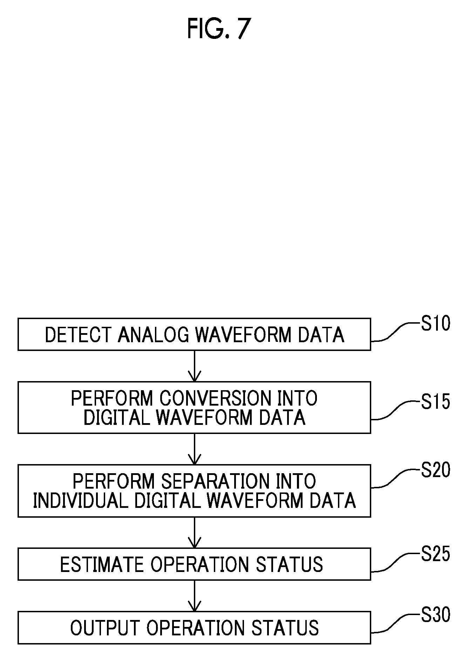

Fig. 7 illustrates an example of a processing flow of the signal processing system according to the embodiment of the present invention.

First, the data detection part 100 detects analog waveform data of a current and a voltage which are supplied to each of the plurality of electrical devices (step 10. The step is referred to as "S" below.). The data detection part 100 supplies the detected analog waveform data to the data conversion part 110. The data conversion part 110 converts the analog waveform data into digital waveform data (S15). The data conversion part 110 supplies the digital waveform data to the data storage part 200. The data storage part 200 supplies the stored digital waveform data to the separation part 205.

The separation part 205 separates the digital waveform data into individual digital waveform data corresponding to each of the plurality of electrical devices (S20). The separation part 205 supplies plural pieces of individual digital waveform data obtained through separation to the operation estimation part 210. The operation estimation part 210 analyzes the individual digital waveform data and estimates an operation status of each of the plurality of electrical devices (S25). The operation estimation part 210 compares information stored in the estimation data storage part 225 and the individual digital waveform data to each other so as to estimate the operation status. The operation estimation part 210 supplies information indicating an estimation result to the output image generation part 215.

The output image generation part 215 obtains an image indicating the operation status corresponding to the information indicating the estimation result, and an area image from the image storage part 235. The output image generation part 215 generates an image obtained by superimposing the obtained image on the area image, as an image indicating the operation status. The output part 220 outputs the image generated by the output image generation part 215, as an image for outputting the operation status of each of the plurality of electrical devices so as to enable visual recognition (S30). For example, the output part 220 transmits the image to the communication terminal 9 from the transmission part 240 and causes the transmitted image to be displayed in the communication terminal 9.

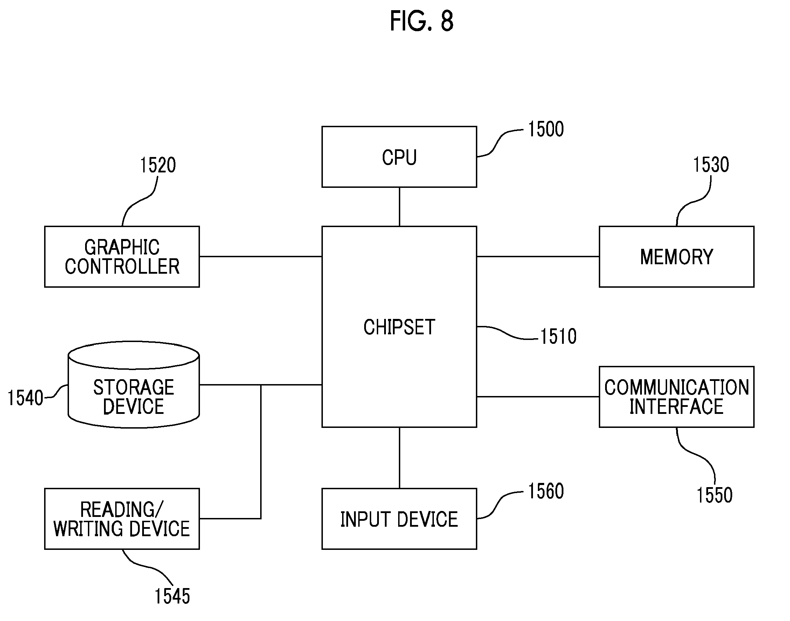

Fig. 8 illustrates an example of a hardware configuration of the signal processing system according to the embodiment of the present invention.

The signal processing system 1 according to the embodiment includes a CPU 1500, a graphic controller 1520, a memory 1530 such as a random access memory (RAM), a read-only memory (ROM), and/or a flash ROM, a storage device 1540 storing data, a reading/writing device 1545, an input device 1560 inputting data, a communication interface 1550, and a chipset 1510. The reading/writing device 1545 reads data from a recording medium and/or writes data in a recording medium. The communication interface 1550 transmits and receives data to and from an external communication device. The chipset 1510 connects the CPU 1500, the graphic controller 1520, the memory 1530, the storage device 1540, the reading/writing device 1545, the input device 1560, and the communication interface 1550 to each other so as to enable communication with each other.

The chipset 1510 connects the memory 1530, the CPU 1500, and the graphic controller 1520 to each other, and thus performs transmission and reception of data between components. The CPU 1500 accesses the memory 1530 and conducts predetermined processing. The graphic controller 1520 controls a display of an external display device. The CPU 1500 operates based on a program stored in the memory 1530 and controls the components. The graphic controller 1520 causes an image to be displayed in a predetermined display device, based on image data which is temporarily stored in a buffer provided in the memory 1530.

The chipset 1510 connects the storage device 1540, the reading/writing device 1545, and the communication interface 1550 to each other. The storage device 1540 stores a program and data used by the CPU 1500 of the signal processing system 1. The storage device 1540 is a flash memory, for example. The reading/writing device 1545 reads a program and/or data from a storage medium storing the program and/or the data, and causes the program and/or the data which have been read, to be stored in the storage device 1540. The reading/writing device 1545 obtains a predetermined program, for example, from a server on the Internet through the communication interface 1550 and causes the obtained program to be stored in the storage device 1540.

The communication interface 1550 transmits and receives data to and from an external device through a communication network. When the communication network is disconnected, the communication interface 1550 may transmit and receive data to and from an external device without passing through the communication network. The input device 1560 such as a keyboard, a tablet, and a mouse is connected to the chipset 1510 through a predetermined interface.

A signal processing program for the signal processing system 1, which is stored in the storage device 1540 is provided to the storage device 1540 through a communication network such as the Internet or a recording medium such as a magnetic recording medium and an optical recording medium. The signal processing program for the signal processing system 1, which is stored in the storage device 1540 is executed by the CPU 1500.

The signal processing program executed by the signal processing system 1 according to the embodiment acts with the CPU 1500 so as to cause the signal processing system 1 to function as the data detection part 100, the data conversion part 110, the data storage part 200, the separation part 205, the operation estimation part 210, the output image generation part 215, the output part 220, the estimation data storage part 225, the estimation result storage part 230, the image storage part 235, and the transmission part 240 which are described with Figs. 1 to 7.

### (Advantages of Embodiment)

The signal processing system 1 according to the embodiment can compare the operation status of each of the plurality of electrical devices to the unique operation status information unique to each of the plurality of electrical devices and thus perform estimation. Thus, it is possible to grasp consumed power of each of the electrical devices even though a sensor and the like for measuring power consumed by the electrical device is not mounted in each of the plurality of electrical devices. The signal processing system 1 can display an image corresponding to the information indicating the operation status obtained through estimation along with an image (for example, floor plan of a house) of the area in which the plurality of electrical devices is installed. Thus, according to the signal processing system 1, it is possible to visually grasp consumed power of each of the plurality of electrical devices more easily than a case of being simply represented by a numeric value, a bar graph, or the like.

The signal processing system 1 display a result obtained by superimposing the character image on the area image (for example, floor plan of a house), and changes the character image based on the estimation result from the operation estimation part 210. Thus, it is possible to grasp consumed power of each of the electrical devices at one view and to cause a user to take interest in the consumed power of each of the electrical devices. For example, the signal processing system 1 disposes the character image at the surroundings of an electric product in which the consumed power exceeds a threshold value, and thus it is possible to visually deliver that the consumed power of the electric product is large. In addition, according to the signal processing system 1, for example, when a vacuum cleaner is not used for a predetermined period, a character image of dust or garbage, or a mushroom or the like is superimposed and displayed on a floor plan, and thus it is possible to visually deliver that cleaning is not performed for a predetermined period.

Hitherto, the embodiment of the present invention is described, but the inventions relating to claims are not limited to the above-described embodiment. It should be noted that all of combinations of features described in the embodiment are not necessary for means for solving the problems of the invention.

### Reference Signs List

- 1: SIGNAL PROCESSING SYSTEM
- 3: TELEVISION
- 3a: ELECTRIC POT
- 3b: REFRIGERATOR
- 5: POWER DISTRIBUTION BOARD
- 7: COMMUNICATION NETWORK
- 9: COMMUNICATION TERMINAL
- 10: MEASURING UNIT
- 20: PROCESSING UNIT
- 50: AREA IMAGE
- 100: DATA DETECTION PART
- 110: DATA CONVERSION PART
- 200: DATA STORAGE PART
- 205: SEPARATION PART
- 210: OPERATION ESTIMATION PART
- 215: OUTPUT IMAGE GENERATION PART
- 220: OUTPUT PART
- 225: ESTIMATION DATA STORAGE PART
- 230: ESTIMATION RESULT STORAGE PART
- 235: IMAGE STORAGE PART
- 240: TRANSMISSION PART
- 400, 402, 404, 406, 408: OPERATION STATUS IMAGE
- 410, 412: OPERATION STATUS IMAGE
- 500, 505, 507, 510: AREA DIVISION IMAGE
- 600, 602: CHARACTER IMAGE
- 700, 702: IMAGE
- 1500: CPU
- 1510: CHIPSET
- 1520: GRAPHIC CONTROLLER
- 1530: MEMORY
- 1540: STORAGE DEVICE
- 1545: READING/WRITING DEVICE
- 1550: COMMUNICATION INTERFACE
- 1560: INPUT DEVICE

## Claims

1. A signal processing system comprising:
a data detection part that detects analog waveform data of a current and a voltage supplied to a plurality of electrical devices;
a data conversion part that converts the analog waveform data detected by the data detection part into digital waveform data;
a separation part that separates the digital waveform data into individual pieces of digital waveform data which respectively correspond to the plurality of electrical devices;
an operation estimation part that estimates an operation status of each of the plurality of electrical devices by analyzing the individual digital waveform data; and
an output part that outputs the operation status of each of the plurality of electrical devices based on an estimation result from the operation estimation part, so as to allow visual recognition.

2. The signal processing system according to Claim 1, wherein
the output part outputs an operation status image indicating the operation status onto an area image indicating an area in which the plurality of electrical devices is installed.

3. The signal processing system according to Claim 2, wherein
the operation estimation part estimates the operation status over time,
the signal processing system further comprising:
an output image generation part that changes the operation status image which is superimposed and output on the area image, based on sequential estimation of the operation estimation part.

4. The signal processing system according to Claim 3, further comprising:
an estimation result storage part that stores estimation result information indicating an estimation result of the operation estimation part; and
an image storage part that stores the operation status image corresponding to the estimation result information,
wherein the output image generation part outputs the operation status image corresponding to the estimation result information to the output part.

5. The signal processing system according to any one of Claims 2 to 4, wherein
the operation status image includes a character image.

6. The signal processing system according to any one of Claims 2 to 5, wherein
the output image generation part causes the operation status image corresponding to each of the plurality of electrical devices to be disposed at a position of the area image corresponding to a position designation instruction, in accordance with the position designation instruction of designating a position, which is received from the outside.

7. The signal processing system according to Claim 6, wherein
the output image generation part causes the operation status image corresponding to each of a plurality of electrical devices which do not correspond to the position designation instruction, to be moved on the area image.

8. The signal processing system according to any one of Claims 1 to 7, further comprising:
an estimation data storage part that stores unique operation status information indicating an operation status unique to each of the plurality of electrical devices, in correlation with each of the plurality of electrical devices,
wherein the operation estimation part compares the individual digital waveform data and the unique operation status information to each other so as to estimate the operation status of each of the plurality of electrical devices.

9. A signal processing method comprising:
a data detecting step of detecting analog waveform data of a current and a voltage supplied to a plurality of electrical devices;
a data converting step of converting the analog waveform data which is detected in the data detecting step, into digital waveform data;
a separating step of separating the digital waveform data into individual digital waveform data corresponding to each of the plurality of electrical devices;
an operation estimating step of estimating an operation status of each of the plurality of electrical devices by analyzing the individual digital waveform data; and
an outputting step of outputting the operation status of each of the plurality of electrical devices based on an estimation result in the operation estimating step, so as to allow visual recognition.

10. A signal processing program which causes a computer to execute:
a data detecting function of detecting analog waveform data of a current and a voltage supplied to a plurality of electrical devices;
a data converting function of converting the analog waveform data which is detected through the data detecting function, into digital waveform data;
a separating function of separating the digital waveform data into individual digital waveform data corresponding to each of the plurality of electrical devices;
an operation estimating function of estimating an operation status of each of the plurality of electrical devices by analyzing the individual digital waveform data; and
an outputting function of outputting the operation status of each of the plurality of electrical devices based on an estimation result in the operation estimating function, so as to allow visual recognition.

## Amended claims

### Amended claims under Art. 19.1 PCT

1. A signal processing system comprising:
a data detection part that detects analog waveform data of a current and a voltage supplied to a plurality of electrical devices;
a data conversion part that converts the analog waveform data detected by the data detection part into digital waveform data;
a separation part that separates the digital waveform data into individual pieces of digital waveform data which respectively correspond to the plurality of electrical devices;
an operation estimation part that estimates an operation status of each of the plurality of electrical devices by analyzing the individual digital waveform data; and
an output part that outputs the operation status of each of the plurality of electrical devices based on an estimation result from the operation estimation part, so as to allow visual recognition,
wherein the output part outputs an operation status image indicating the operation status onto an area image indicating an area in which the plurality of electrical devices is installed,
the operation status image includes a character image, and
the character image is displayed on the area image when the estimation result by the operation estimation part satisfies a predetermined condition.

2. The signal processing system according to Claim 1, wherein
the character image is displayed in the vicinity of a position of the corresponding electrical device on the area image.

3. The signal processing system according to Claim 1 or 2, wherein
the character image is displayed on the area image when the estimation result by the operation estimation part indicates presence of a new electrical device.

4. The signal processing system according to any one of Claims 1 to 3, wherein
the character image is displayed on the area image when the estimation result by the operation estimation part indicates that consumed power of each of the plurality of electrical devices is equal to or greater than a predetermined threshold value.

5. The signal processing system according to any one of Claims 1 to 4, wherein
the character image is displayed on the area image when an operation status of each of the plurality of electrical devices in the estimation result by the operation estimation part indicates that the electrical device is not operated for a predetermined period.

6. The signal processing system according to any one of Claims 1 to 5, wherein
the character image is an image indicating a state reminded from the estimation result, or an image indicating an act of a user reminded from the estimation result.

7. The signal processing system according to any one of Claims 1 to 6, wherein
the operation estimation part estimates the operation status over time,
the signal processing system further comprising:
an output image generation part that changes the operation status image which is superimposed on the area image and output, based on sequential estimation of the operation estimation part.

8. The signal processing system according to Claim 7, further comprising:
an estimation result storage part that stores estimation result information indicating an estimation result of the operation estimation part; and
an image storage part that stores the operation status image corresponding to the estimation result information,
wherein the output image generation part outputs the operation status image corresponding to the estimation result information to the output part.

9. The signal processing system according to Claim 7 or 8, wherein
the output image generation part causes the operation status image corresponding to each of the plurality of electrical devices to be disposed at a position of the area image corresponding to a position designation instruction, in accordance with the position designation instruction of designating a position, which is received from the outside.

10. The signal processing system according to Claim 9, wherein
the output image generation part causes the operation status image corresponding to each of a plurality of electrical devices which do not correspond to the position designation instruction, to be moved on the area image.

11. The signal processing system according to any one of Claims 1 to 10, further comprising:
an estimation data storage part that stores unique operation status information indicating an operation status unique to each of the plurality of electrical devices, in correlation with each of the plurality of electrical devices,
wherein the operation estimation part compares the individual digital waveform data and the unique operation status information to each other so as to estimate the operation status of each of the plurality of electrical devices.

12. A signal processing method comprising:
a data detecting step of detecting analog waveform data of a current and a voltage supplied to a plurality of electrical devices;
a data converting step of converting the analog waveform data which is detected in the data detecting step, into digital waveform data;
a separating step of separating the digital waveform data into individual digital waveform data corresponding to each of the plurality of electrical devices;
an operation estimating step of estimating an operation status of each of the plurality of electrical devices by analyzing the individual digital waveform data; and
an outputting step of outputting the operation status of each of the plurality of electrical devices based on an estimation result in the operation estimating step, so as to allow visual recognition,
wherein, in the outputting step, an operation status image indicating the operation status is output onto an area image indicating an area in which the plurality of electrical devices is installed,
the operation status image includes a character image, and
the character image is displayed on the area image when the estimation result in the operation estimation step satisfies a predetermined condition.

13. A signal processing program which causes a computer to execute:
a data detecting function of detecting analog waveform data of a current and a voltage supplied to a plurality of electrical devices;
a data converting function of converting the analog waveform data which is detected through the data detecting function, into digital waveform data;
a separating function of separating the digital waveform data into individual digital waveform data corresponding to each of the plurality of electrical devices;
an operation estimating function of estimating an operation status of each of the plurality of electrical devices by analyzing the individual digital waveform data; and
an outputting function of outputting the operation status of each of the plurality of electrical devices based on an estimation result in the operation estimating function, so as to allow visual recognition,
wherein the outputting function outputs an operation status image indicating the operation status onto an area image indicating an area in which the plurality of electrical devices is installed,
the operation status image includes a character image, and
the character image is displayed on the area image when the estimation result by the operation estimation function satisfies a predetermined condition.
